# EUROPEAN PATENT APPLICATION

(11) **EP 3 626 791 A1**
(43) Date of publication of application: **25.03.2020**
(21) Application number: 19187472.6
(22) Date of filing: 22.07.2019
(51) Int. Cl.: C09J 7/00, G06F 1/16, B32B 27/00, A63F 13/98, H04M 1/725, H04M 1/02, H04M 1/18, C09J 7/29

(54) **PROTECTIVE FILM FOR MOBILE PHONE WITH GAME FUNCTION**

(30) Priority: 20.09.2018 CN 201811103317
(71) Applicant: Yang, Zechuan, Shenzhen, Guangdong (CN)
(72) Inventor: Yang, Zechuan, Shenzhen, Guangdong (CN)
(74) Representative: Cabinet Chaillot

(57) **Abstract**

The invention discloses a protective film for mobile phone with game function, comprising a protective film body, wherein the structure of the protective film body is divided into upper, middle and lower layers; the upper layer is the substrate layer, the middle layer is the ITO film, and the lower layer is the AB glue layer; the protective film body is pasted on the display screen of the mobile phone through the AB glue layer; the protective film body is provided with a display layer; the display layer is electrically connected to the sensing layer disposed on the button through the nanocomposite circuit. The invention has the advantages of simple in structure, easy to carry, practical and efficient.

## Description

### BACKGROUND OF THE INVENTION

### 1. Field of the Invention

The invention relates to a protective film, and in particular, to a protective film for mobile phone with game function.

### 2. Description of the Related Art

The popular mobile phone shooting game, such as the popular PUBG, consumes the mobile phone configuration and is difficult to operate, and the fault tolerance rate is relatively low. For example, in the operation of the move button, direction button, sight-open button, and shooting button, these four buttons require the operation to be completed at the same time in a very short time, but on most mobile phones can only use the left and right thumb to operate, which is relatively easy to fail to press and to operate incorrectly.

### SUMMARY OF THE INVENTION

The object of the invention is to design a protective film for mobile phone with game function. By providing a nanocomposite circuit on the protective film, the human body current is transmitted to the other end of the circuit by pressing one end of the finger, thereby the control of the touch area from the non-touch area of the mobile phone is realized.

In order to solve the technical issues above, the invention provides a protective film for mobile phone with game function, comprising a protective film body, wherein the structure of the protective film body is divided into upper, middle and lower layers; the upper layer is the substrate layer, the middle layer is the ITO film, and the lower layer is the AB glue layer; the protective film body is pasted on the display screen of the mobile phone through the AB glue layer; the protective film body is provided with a display layer; the display layer is electrically connected to the sensing layer disposed on the button through the nanocomposite circuit.

Further: the protective film body is provided with two display layers, and the two display layers are respectively connected with a button with a sensing layer through the nanocomposite circuit; the outside of the mobile phone is sleeved with a matching protective case, and the protective case is provided with through grooves matching with the two buttons.

Further: the two display layers are disposed at the bottom of the protective film body, and the upper and lower surfaces of the protective film body are respectively provided with a nanocomposite circuit; one end of each of the two nanocomposite circuits is connected to a display layer, and the other end of each of the two nanocomposite circuits is respectively connected to a button.

Further: the sensing layer is composed of a PET material layer and a conductive pattern layer disposed on the PET material layer, and the conductive pattern layer is formed of an ultra-low resistance transparent conductive film.

Further: the thickness of the ultra-low resistance transparent conductive film is 5 to 100 nm, preferably 8 to 10 nm.

Further: the ultra-low resistance transparent conductive film comprises:
a first ITO conductive layer;
a first anti-oxidation layer, which is disposed on the surface of the first ITO conductive layer;
a metal layer, which is disposed on the surface of the first anti-oxidation layer away from the first ITO conductive layer;
a second anti-oxidation layer, which is disposed on the surface of the metal layer away from the first anti-oxidation layer;
a second ITO conductive layer, which is disposed on the surface of the second anti-oxidation layer away from the metal layer.

Further: the metal layer is a gold layer or a silver layer, and the thickness of the metal layer is preferably 6 to 12 nm.

Further: the shape of the protective film body matches with the display screen of the mobile phone.

After adopting the above structure, the invention utilizes a capacitive touch technology to perform work by using human body current sensing; the human body current is transmitted to the other end of the circuit by pressing one end of the finger, thereby the control of the touch area from the non-touch area of the mobile phone is realized. The invention also has the advantages of simple in structure, easy to carry, practical and efficient.

### BRIEF DESCRIPTION OF THE DRAWINGS

The invention is further described in detail hereinafter with reference to the drawings and specific embodiments.
FIG. 1 is an outside view illustrating the invention.
FIG. 2 is a layer structure of the protective film body of the invention.

### DETAILED DESCRIPTION OF THE PREFERRED EMBODIMENTS

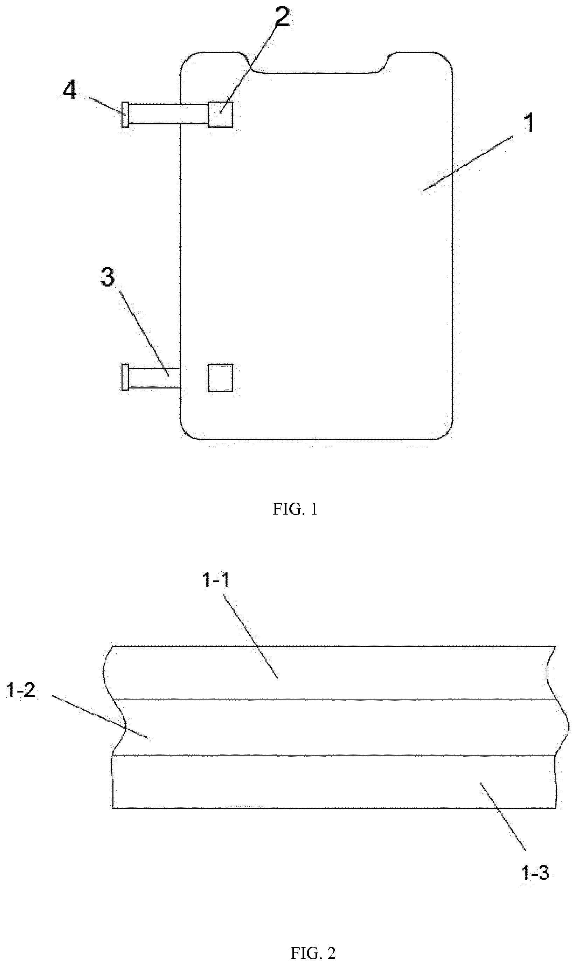

A protective film for mobile phone with game function, as shown in FIG. 1 and FIG. 2, comprising a protective film body 1, wherein the structure of the protective film body is divided into upper, middle and lower layers; the upper layer is the substrate layer 1-1, the middle layer is the ITO film 1-2, and the lower layer is the AB glue layer 1-3; the protective film body is pasted on the display screen of the mobile phone through the AB glue layer 1-3; the protective film body 1 is provided with a display layer 2; the display layer 2 is electrically connected to the sensing layer disposed on the button 4 through the nanocomposite circuit 3. The invention utilizes a capacitive touch technology to perform work by using human body current sensing; the human body current is transmitted to the other end of the circuit by pressing one end of the finger, thereby the control of the touch area from the non-touch area of the mobile phone is realized.

The protective film body 1 as shown in FIG. 1 is provided with two display layers 2, and the two display layers 2 are respectively connected with a button with a sensing layer through the nanocomposite circuit 3; the outside of the mobile phone is sleeved with a matching protective case, and the protective case is provided with through grooves matching with the two buttons.

The two display layers 2 as shown in FIG. 1 are disposed at the bottom of the protective film body 1, and the upper and lower surfaces of the protective film body 1 are respectively provided with a nanocomposite circuit 3; one end of each of the two nanocomposite circuits 3 is connected to a display layer 2, and the other end of each of the two nanocomposite circuits 3 is respectively connected to a button. The invention uses the novel nanocomposite circuit to paste and export the line on the protective film of the mobile phone, and makes the button mode outside the touch screen, so that the user uses the left and right index fingers to reduce the operation difficulty and mistakes.

The sensing layer is composed of a PET material layer and a conductive pattern layer disposed on the PET material layer, and the conductive pattern layer is formed of an ultra-low resistance transparent conductive film.

The thickness of the ultra-low resistance transparent conductive film is 5 to 100 nm, preferably 8 to 10 nm.

The ultra-low resistance transparent conductive film comprises: a first ITO conductive layer, a first anti-oxidation layer, a metal layer, a second anti-oxidation layer and a second ITO conductive layer; the first anti-oxidation layer is disposed on the surface of the first ITO conductive layer; the metal layer is disposed on the surface of the first anti-oxidation layer away from the first ITO conductive layer; the second anti-oxidation layer is disposed on the surface of the metal layer away from the first anti-oxidation layer; the second ITO conductive layer is disposed on the surface of the second anti-oxidation layer away from the metal layer.

The metal layer is a gold layer or a silver layer, and the thickness of the metal layer is preferably 6 to 12 nm.

The shape of the protective film body 1 matches with the display screen of the mobile phone.

## Claims

1. A protective film for mobile phone with game function, comprising a protective film body (1), wherein the structure of the protective film body is divided into upper, middle and lower layers; the upper layer is the substrate layer (1-1), the middle layer is the ITO film (1-2), and the lower layer is the AB glue layer (1-3); the protective film body is pasted on the display screen of the mobile phone through the AB glue layer (1-3); the protective film body (1) is provided with a display layer (2); the display layer (2) is electrically connected to the sensing layer disposed on the button (4) through the nanocomposite circuit (3).

2. The protective film for mobile phone with game function according to claim 1, wherein the protective film body (1) is provided with two display layers (2), and the two display layers (2) are respectively connected with a button with a sensing layer through the nanocomposite circuit (3); the outside of the mobile phone is sleeved with a matching protective case, and the protective case is provided with through grooves matching with the two buttons.

3. The protective film for mobile phone with game function according to claim 2, wherein the two display layers (2) are disposed at the bottom of the protective film body (1), and the upper and lower surfaces of the protective film body (1) are respectively provided with a nanocomposite circuit (3); one end of each of the two nanocomposite circuits (3) is connected to a display layer (2), and the other end of each of the two nanocomposite circuits (3) is respectively connected to a button.

4. The protective film for mobile phone with game function according to claim 1, wherein the sensing layer is composed of a PET material layer and a conductive pattern layer disposed on the PET material layer, and the conductive pattern layer is formed of an ultra-low resistance transparent conductive film.

5. The protective film for mobile phone with game function according to claim 4, wherein the thickness of the ultra-low resistance transparent conductive film is 5 to 100 nm, preferably 8 to 10 nm.

6. The protective film for mobile phone with game function according to claim 4, wherein the ultra-low resistance transparent conductive film comprises:
a first ITO conductive layer;
a first anti-oxidation layer, which is disposed on the surface of the first ITO conductive layer;
a metal layer, which is disposed on the surface of the first anti-oxidation layer away from the first ITO conductive layer;
a second anti-oxidation layer, which is disposed on the surface of the metal layer away from the first anti-oxidation layer;
a second ITO conductive layer, which is disposed on the surface of the second anti-oxidation layer away from the metal layer.

7. The protective film for mobile phone with game function according to claim 6, wherein the metal layer is a gold layer or a silver layer, and the thickness of the metal layer is preferably 6 to 12 nm.

8. The protective film for mobile phone with game function according to claim 1, wherein the shape of the protective film body (1) matches with the display screen of the mobile phone.
